# EUROPEAN PATENT APPLICATION

(11) **EP 4 826 665 A1**
(43) Date of publication of application: **21.10.2026**
(21) Application number: 26172757.2
(22) Date of filing: 16.04.2026
(51) Int. Cl.: G06T 15/10, G06T 15/30, G06T 19/00

(54) **METHOD AND SYSTEM FOR REAL-TIME CROSS-SECTION VIEW OF A CONSTRUCTION SITE**

(30) Priority: 17.04.2025 FI 20253143
(71) Applicant: Vektorio Oy, 33100 Tampere (FI)
(72) Inventor: Vesanen, Juha, 33100 Tampere (FI)
(74) Representative: Kolster Oy Ab

(57) **Abstract**

A computer implemented method (100) for generating a real-time two-dimensional cross-section view of a construction site with a graphics pipeline comprising at least a vertex shader and fragment shader, the method comprising defining (101) a cross-section plane (30) of a three-dimensional model of the construction site; determining (102) an orthogonal view frustum (25) aligned with the cross-section plane (30); determining (103) an offset plane (31) parallel to the cross-section plane (30) at an offset distance (D) from the cross-section plane (30); determining (104) a first orthogonal projection matrix, wherein the first orthogonal projection matrix is sheared in a first direction; determining (105) a first orthogonal projection using the first orthogonal projection matrix; generating (106) a rasterized image of the orthogonal view frustum (25) with the fragment shader on the cross-section plane (30) based on a resolution of a graphics display; testing (107) depth of each fragment if each pixel of the fragment with respect to the cross-section plane (30) and the offset plane (31); in response to a pixel of a fragment is positioned between the cross-section plane (30) and the offset plane (31), including (108) the pixel of the fragment; in response to a pixel of a fragment is not positioned between the cross-section plane (30) and the offset plane (31), discarding (109) the pixel of the fragment; and displaying (110) the rasterized image from the cross-section plane (30) on the graphics display.

## Description

### FIELD OF THE INVENTION

The present invention relates to a computer implemented method of generating a real-time two-dimensional cross-section view of a construction site.

### BACKGROUND OF THE INVENTION

Generating a real-time cross-section view from a 3D model of a construction site is highly computation intensive task because of the real-time requirements. The 3D models of the construction site typically include on one hand many details and on the other hand long or large structures with uniform shapes and surfaces.

Generating a cross-section view in real-time requires calculating new 3D primitives for every frame to be displayed on a graphics display. With a typical frame rate of 60 fps and a 3D model of large construction site this requires significant processing capacity especially when the angle of view and distance is freely selected by a user. The cross-section view may be required on different kind of end-user devices e.g., portable user devices, or special-purpose devices on vehicles.

### BRIEF DESCRIPTION OF THE INVENTION

An objective of the present invention to provide a method and an system for implementing the method so as to overcome the above problems so as to alleviate the above disadvantages. The objects of the invention are achieved by a computer implemented method and an arrangement which are characterized by what is stated in the independent claims. The preferred embodiments of the invention are disclosed in the dependent claims.

In this disclosure, a real-time two-dimensional cross-section view of a construction site is generated using a computer implemented graphics pipeline, and especially a vertex shader and a fragment shader of the graphics pipeline. The method comprises determining a cross-section plane of a three-dimensional model of the construction site the user is observing firstly by determining the view frustum, wherein the cross-section plane is aligned with the view frustum and further determining an offset plane parallel to the cross-section plane at a distance. A sheared orthogonal projection of the 3D model of the construction site is determined with the vertex shader and pixels of the triangles located between the cross-section plane and the offset plane are drawn with the fragment shader. Finally, a rasterized image of the cross-section is displayed on the user device display.

### BRIEF DESCRIPTION OF THE DRAWINGS

In the following the invention will be described in greater detail by means of preferred embodiments with reference to the attached drawings, in which
Figure 1 illustrates schematically a construction site in 3D view;
Figure 2 illustrates schematically the construction site in 3D view with a user and a figurative cross-section view window;

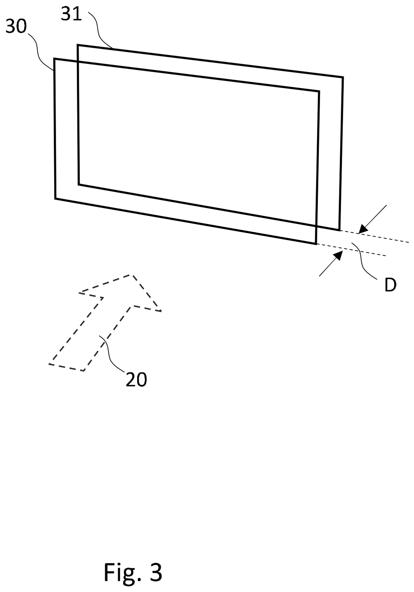

Figure 3 illustrates schematically a cross-section plane and an offset plane;

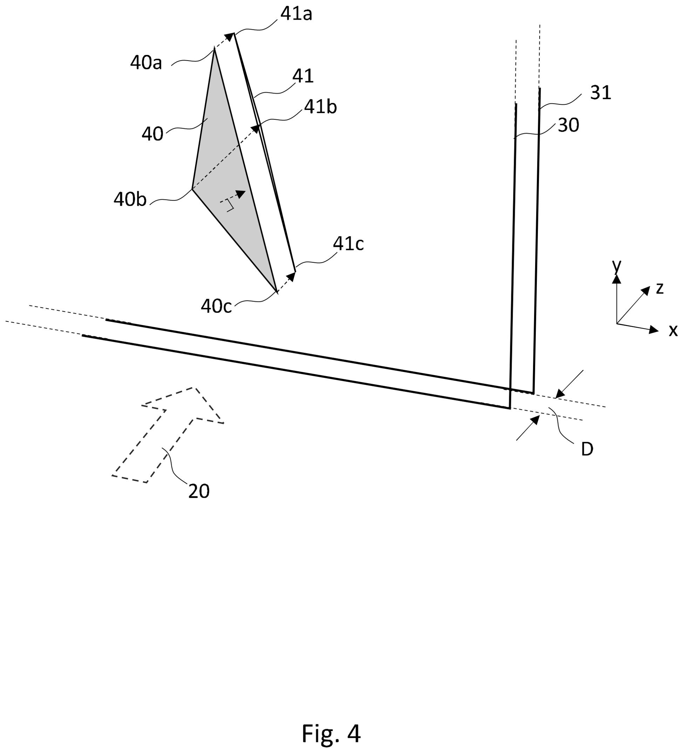

Figure 4 illustrates schematically a part of cross-section plane with triangle and a projection of the triangle on a part of an offset plane;

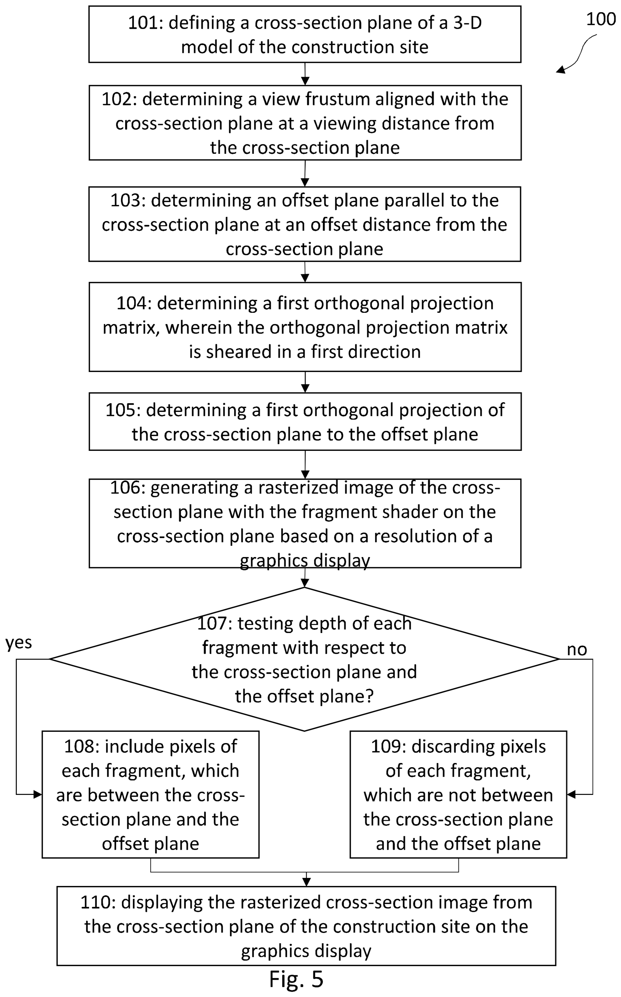

Figure 5 illustrates an embodiment of the computer implemented method;
Figure 6a illustrates schematically a triangle and a version of the triangle sheared in a first direction;
Figure 6b illustrates schematically a rasterized projection of a sheared triangle;
Figure 7a illustrates schematically the triangle and a version of the triangle sheared in a second direction;
Figure 7b illustrates schematically the rasterized projection of a sheared triangle;
Figure 8 illustrates schematically an embodiment of an apparatus;
Figure 9 illustrates schematically the construction site in 3D view with a figurative user using a user device, and a real-time cross-section view displayed at the user device display with figurative data sources used.
Figure 10 illustrates schematically the operation of the method executed on the graphics rendering system for real-time two-dimensional cross-section viewing of the construction site.

### DETAILED DESCRIPTION OF THE INVENTION

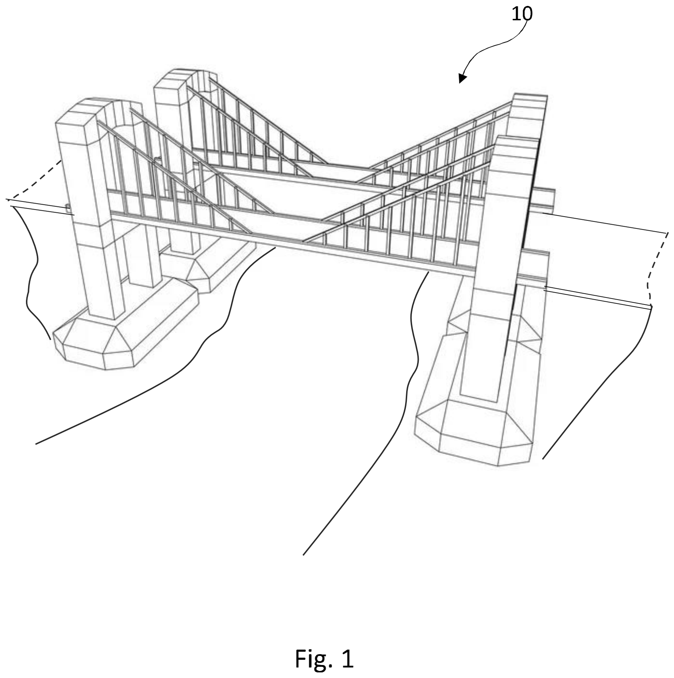

In construction, a building, a whole construction site or an infrastructure construction site is described as 3D model. In construction this is often referred as Building Information Model (BIM). Various operators perform their work and operation based on these 3D models or a BIM. The data is used also by other systems on the construction sites. This disclosure describes a method to generate a cross-section view in an arbitrary direction of a building, construction site or an infrastructure site in real-time from the 3D construction site model of from the BIM. Figure 1 is illustrating a construction site 10 (a bridge in this case). A construction site typically comprises fixed structures with several hidden sections covered by other structures or there are sections of the construction that have not been built yet. Having the possibility to view in real-time any cross-section of an already build structure or for structure to be build can be very useful for many operators at a construction site.

A computer graphics pipeline (aka rendering pipeline) is a framework within computer graphics that outlines the necessary procedures for transforming a three-dimensional (3D) scene into a two-dimensional (2D) representation to be drawn on a screen such as computer display. Once a 3D model is generated, the graphics pipeline converts the model into a visually perceivable format on the computer display. However, due to several dependence on different software and hardware configurations and desired display attributes, a universally applicable graphics pipeline does not exist. Therefore, graphics application programming interfaces (APIs), such as Direct3D, OpenGL and WebGL were developed to standardize common procedures and oversee the graphics pipeline of a given hardware accelerator. The 3D pipeline usually refers to the most common form of computer 3D rendering called 3D triangle rendering. The triangles are 2D shapes in a 3D space with three vertices, but also polygons with higher number of vertices than three may be used. The triangle is defined by its three vertices and a normal vector - the normal vector serves to indicate the front face of the triangle and is a vector that is perpendicular to the surface of the triangle. Also, polygons with more than three vertices are defined on one plane. It should be noted that triangles, including triangle, are defined within the limits of the digital representation, which is typically in a 32-bit floating point format. The triangle is a 2D object defining the surface with vertices and it does not have a depth or a thickness.

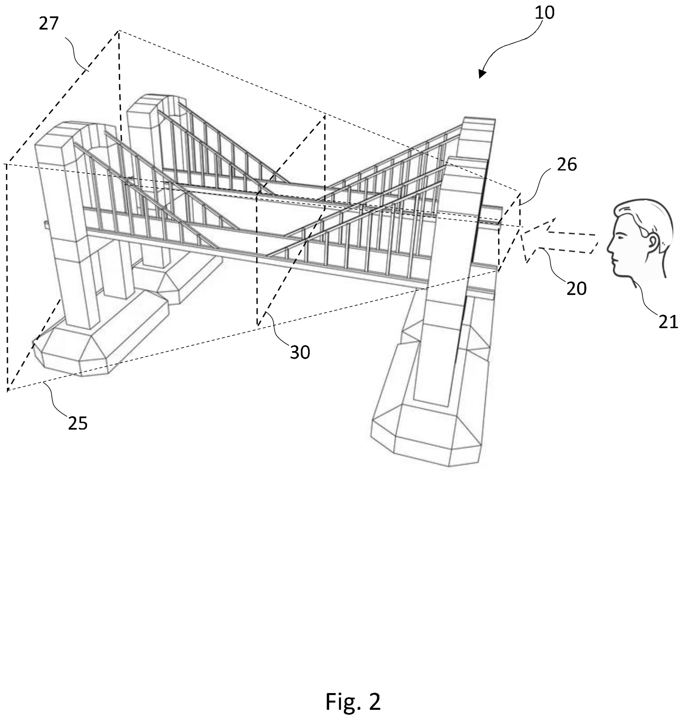

Figure 2 is illustrating the construction site 10 and a figurative user 21 observing a 3D model of the construction from viewing point, and the viewing angel or perspective is usually called a camera forward vector 20. The 3D graphics system determines a view of the construction site 10 based on selected viewing settings such as direction and perspective, and these settings describe a viewing frustum 25. The viewing frustum 25 can be described as a truncated pyramid with a near end 26 and a far end 27, which ends 26, 27 define the part of the 3D model of the construction site that will be rendered on the final image on a display. The desired cross-section 30 is shown in the Figure 2.

The graphics pipeline comprises a vertex shader which is processing each vertex's attributes like position in 3D space, colour, normal, and texture coordinates before the triangles are rasterized. The vertex shader performs transformations, such as converting 3D coordinates to 2D display coordinates (using model, view, and projection matrices. The output of the vertex shader includes the transformed vertex position, and it may also pass additional data like colours or texture coordinates to a fragment shader. The fragment shader processes pixel data, and it is taking into account the display resolution and other display parameters. The fragment shader takes interpolated data from the vertex shader and determines the final colour and other attributes of each pixel or a fragment that will be drawn on the display. The fragment shader may perform operations like texture mapping, lighting calculations, and colour blending to generate the final pixel colour.

To achieve this real-time rendering, a graphics pipeline has to process a frame frequently to refresh the display at a frame rate convenient for the user. The processing load may be significant based on the complexity of the view.

In the skill of the art, a cross-section view of a 3D construction model in a camera view would be determined by analysing the geometry of the 3D construction model and by identifying the triangles that are intersecting with the cross-section plane. The analysis would further determine the intersection lines and generated either lines or very sharp triangles to be transformed to pixels by the fragment shader.

A computer implemented method 100 for determining a 2D real-time cross section view in a 3D graphics system comprises by generating an orthogonal projection in the direction of the selected view, further referred as the view frustum 25. The selected view direction is further referred as a camera forward vector 20. The cross-section view is determined as a plane with its normal aligned with the camera forward vector 20 at a viewing distance from the view frustum 25. It should be noted that the cross-section view may be a plane in any direction with respect to a global coordinate system used. The plane is called a cross-section plane 30. For practical applications, the cross-section view is usually selected so that the camera forward vector 20 and the normal of the plane are in a horizontal attitude with respect to the global coordinate system.

The orthogonal projection results in every plane of the view appearing in an affine transformation on the view frustum 25. There are various orthogonal projections known in the literature. It is essential that a dimension is transformed affinely so that relative distances of points on a same line are preserved in the transformed geometry. The three dimensions may all be transformed in the same way or differently as long as each dimension is transformed in an affine manner. In contrast, a perspective projection transforms a view as seen by a camera, i.e. through a camera viewpoint or a camera finder. In perspective projection, the relative distances of points on a same line are not preserved in the transformed geometry.

The 2D cross-section view is determined in real-time by determining 101 a cross-section plane 30 from a three-dimensional model of the construction site with its normal aligned with the camera forward vector 20 at a viewing distance from a viewing point. An orthogonal view frustum 25 is determined 102 aligned with the cross-section plane 30, wherein the cross-section plane 30 intersects the view frustum 25. An offset plane 31 is determined 103 in parallel with the cross-section plane 30 and is placed with its normal also aligned with the camera forward vector 20 at an offset distance D from the cross-section plane 30. The offset distance D may be either in front or on the back of the cross-section plane 30 when viewed from the view frustum 25. The offset distance D may be small in length with respect to the 3D construction site model to be rendered. In practice the offset distance D, maybe e.g. 1-10 cm but its length is not restricted to this measure. For obvious reasons, the offset distance D may be scaled with the scale of the 3D construction site and the application in question. A first orthogonal projection matrix is determined 104, wherein the first orthogonal projection matrix is sheared in a first direction. An orthogonal projection matrix generates a slanted or sheared projection of the triangles. This means that the surface of the polygon is changed to a direction depending on the coefficients of the orthogonal proception matrix. The direction of the slanting may be in any direction, e.g. in x, y, z coordinates, wherein x, y and z-refer to the global unit vectors of the camera space. Fig-ures 4 and 6a are illustrating the projection of a triangle 40, wherein the triangle 40 is slanted to form triangle 41. In this example, one of the triangle 40 vertices, that is 40b, is shifted to be 41b.

In sheared projection matrices, the term shear refers to the amount that the far plane shifts up, down, left, or right relative to the forward direction of the camera. This can produce a skewed projection matrix, with different effects for the type of projection matrix being used. An orthographic projection matrix Pₒ may be defined e.g. by Equation 1: ${P}_{o} = \left[\begin{matrix}\frac{1}{r} & 0 & 0 & 0 \\ 0 & \frac{1}{t} & 0 & 0 \\ 0 & 0 & \frac{- 2}{f - n} & - \frac{f + n}{f - n} \\ 0 & 0 & 0 & 1\end{matrix}\right]$ [1], where r is the distance from the centre to the right edge of the frustum, *t* is the distance from the centre to the top edge of the frustum, *f* is the far plane distance, and n is the near plane distance. The orthographic projection matrix Pₒ and the later matrices are presented in a column-major order. To introduce a sheared orthographic projection matrix, the Equation 1 should be modified by a shearing factor s and optionally an aspect ratio *α* to form a sheared projection matrix Pₕ as in the example of Equation 2, ${P}_{h} = \left[\begin{matrix}\frac{1}{r} & 0 & 0 & 0 \\ 0 & \frac{1}{t} & 0 & 0 \\ s & 0 & \frac{- 2}{f - n} & - \frac{f + n}{f - n} \\ zn ⋅ s & 0 & 0 & 1\end{matrix}\right]$ [2],

In Equation 2, s is the shearing amount, *zn* (znear) is the distance from the viewer to the near clipping plane in the viewing frustum. The term zn defines the closest depth at which geometry will be rendered. Objects closer than this distance will be clipped and not displayed. Term *f* is the far plane distance, and n is the near plane distance. For example, Pₕ of Equation 2 is shearing the orthographic projection in a horizontal direction.

Equation 3 is describing another example of sheared projection matrix Pᵥ, which is shearing the orthographic projection is a vertical direction: ${P}_{v} = \left[\begin{matrix}\frac{1}{r} & 0 & 0 & 0 \\ 0 & \frac{1}{t} & 0 & 0 \\ 0 & s ⋅ a & \frac{- 2}{f - n} & - \frac{f + n}{f - n} \\ 0 & zn ⋅ s ⋅ α & 0 & 1\end{matrix}\right]$ [3],

In Equation 3, the terms *s* and *zn* are as described with Equation 2, α is the aspect ratio of the view used in rendering, *f* is the far plane distance, and n is the near plane distance.

Obviously, the shearing can be done in multiple directions and amounts, so the sheared projection matrix can be defined in multiple ways. The relevant point is that the amount that the far plane shifts up, down, left, or right or some combination of horizontal and vertical shift relative to the forward direction of the camera. The sheared projection matrix can be defined in an on-centre or in an off-centre form referring to the centre location of the viewing frustum with camera centre line. This selection is reflected in the elements of the sheared projection matrix.

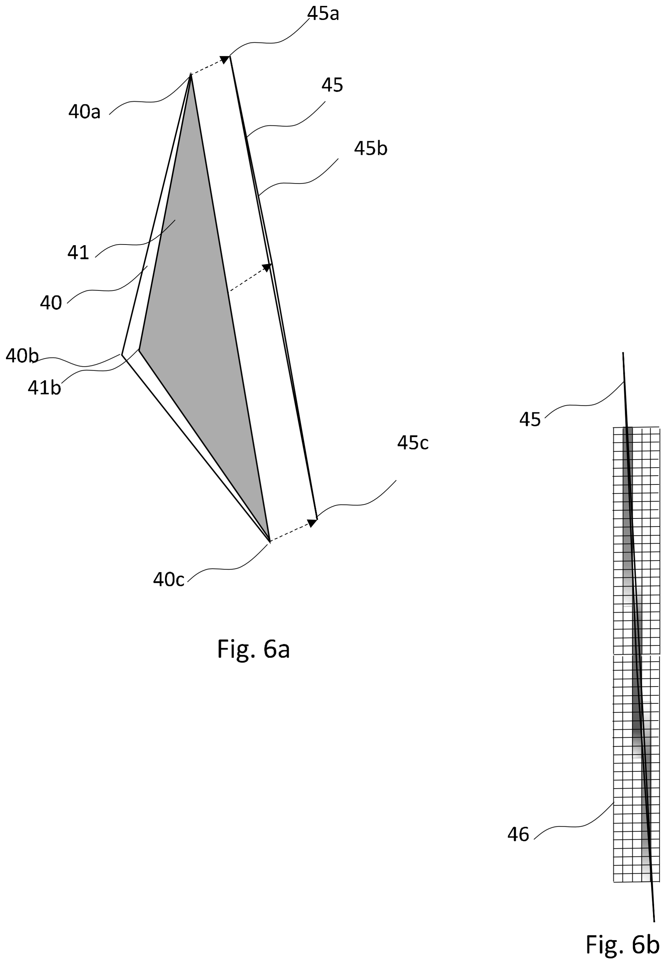

A first orthogonal projection of the cross-section plane 30 is determined 105 on the offset plane 31 using the first orthogonal projection matrix. Then, a rasterized image of the cross-section plane 30 is generated 106 with the fragment shader on the cross-section plane 30 based on a resolution of a graphics display. The vertices 40a, 41b, 40c of the triangle 41 of Figure 6a are projected to form triangle 45, with respective vertices 45a, 45b, 45c, wherein the triangle 45 is very narrow when viewed from the direction of the camera forward vector 20. Figure 6b is illustrating a rasterized image of fragment, e.g. a section of a projected triangle 45.

Then, the fragment is depth tested 107 against the cross-section plane 30 and the offset plane 31. If a pixel of a fragment is positioned between the cross-section plane and the offset plane 31, the pixel of the fragment will be included 108 in the image. If a pixel of a fragment is not positioned between the cross-section plane and the offset plane 31, the pixel of the fragment will be discarded 108 from the image. Thus, only pixels between said two planes are drawn. This is called a pass, and, in this method, it is further referred as the first pass of the graphics pipe-line. Finally, the rasterized image is displayed 110 from the view frustum 25 on the graphics display.

The required processing capacity of the computer implemented method is significantly less than the prior art methods of analysing the geometry of the whole 3D construction site model. It should be noted that a projection of the geometry is done in any case in a graphics system. Typically, this is a perspective projection when the geometry is of the 3D construction site model is projected on a view frustum 25 viewed from a camera viewpoint. That means that the first pass of the fragment shader with a sheared orthogonal projection matrix is not actually adding processing load to the graphics system. The only additional processing is the depth checking of fragments against the depth information of the cross-section plane 30 and the offset plane 31. Only those pixels of the fragments that fall between the cross-section plane 30 and the offset plane 31 are eventually drawn on the graphic display. On the other hand, in the prior art the additional analysis on the geometry and determining the intersection of the 3D construction site model and the cross-section plane 30 introduce a significant processing load, that may be very high if the 3D construction site model is a large model as is the case with 3D construction site models in construction. The analysis task maybe optimized by developing heuristics i.e., programmed rules to analyse the tringles of the 3D construction site model in different phases to limit the number of triangles to be analysed completely.

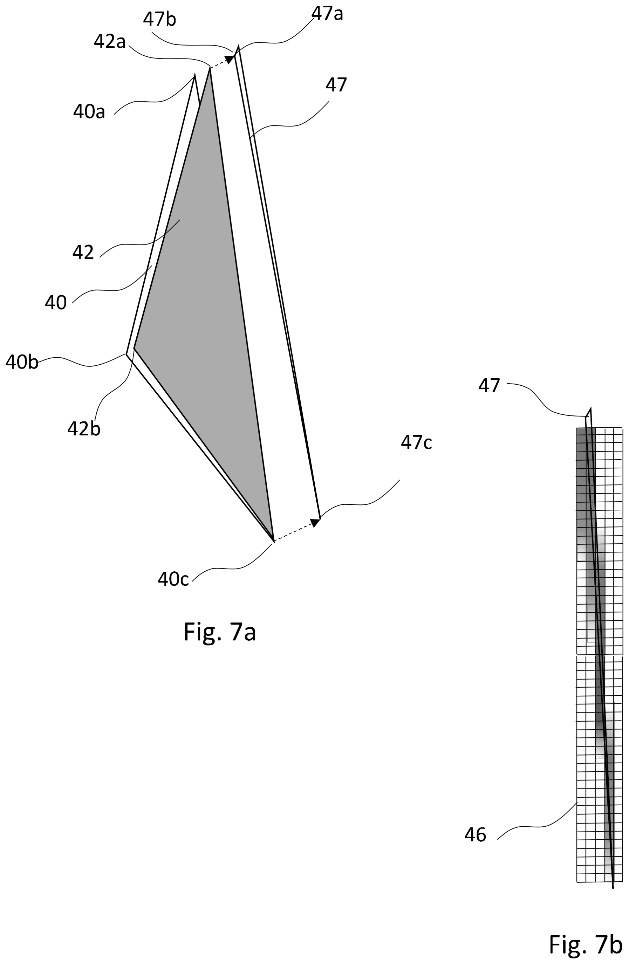

In another embodiment of the computer implemented method, a second orthogonal projection matrix is determined, wherein the second orthogonal projection matrix is sheared in a different direction than the first orthogonal projection matrix. A second pass of the graphics pipeline is performed on the cross-section plane 30 with the second orthogonal projection matrix. Figure 7a is illustrating the projection on the triangle 40 in another direction with the second projection matrix resulting on second projected triangle 42. The vertices 42a, 42b, 40c of the triangle 42 of Figure 7a are projected to form triangle 47, with respective vertices 47a, 47b, 47c, wherein the triangle 47 is also very narrow when viewed from the direction of the camera forward vector 20 but slightly different from the triangle 45 of Figure 6b. Figure 7b is illustrating a rasterized image of a fragment, e.g. a section of a projected triangle 47. A single pass with an orthogonal projection sheared in the first direction may result in no shearing for triangles that are aligned with the direction of the first orthogonal projection matrix. In such a situation, said triangles would not increase their projected coverage in the final view i.e., during rasterization said triangles would not colour any pixels or would colour them only vaguely. Performing two different passes with an orthogonal projection sheared in different directions produces coloured pixels in multiple directions. Also, in a single pass, a surface of tringle may become fully aligned with the camera forward vector 20, and thus end up in a situation, wherein during rasterization said triangles would not colour any pixels by the fragment shader. Performing two passes with an orthogonal projection sheared in different directions will cause that all triangles will colour pixels during rasterization at least during one of the two passes.

Although the two passes add an extra amount of processing load to the fragment shader, that is the second pass of the fragment shader, it is still significantly less than compared to the known method of analysing the geometry of the 3D construction site model and identifying all triangles that would need to be modified for each frame to be displayed. The analysis would need to be done for each frame. The first and second orthogonal projection matrices are favourably oriented perpendicularly with respect to the camera forward vector 20.

In another embodiment of the computer implemented method, the second orthogonal projection matrix is sheared in a direction approximately 90 degrees with respect to the first orthogonal projection matrix. With two passes having projection matrices sheared in a direction approximately 90 degrees with respect to each other the produces coloured pixels in multiple directions during by the fragment shader.

In another embodiment of the computer implemented method at least one of the first and the second orthogonal projection matrices are determined based on the resolution of the display. The smaller the resolution the display has, the stronger shearing is required to generate a projection on the offset plane 31, that would result in visible pixels for aligned triangles when the fragment shader is generating the pixel to be displayed. In fact, the finer the structure of the geometry of the 3D construction site model is, the smaller triangles of the 3D construction site model are, and the shearing of the small triangles generates respectively narrower projections. Therefore, with higher resolution, the shearing effect should be stronger, the at least one of the first and second projection matrices should generate a stronger shearing effect on the triangles.

In another embodiment of the computer implemented method the first and the second orthogonal projection matrices are determined based on the aspect ratio of the display. The first and second projection matrices may be determined based on the aspect ratio so that the shearing effect of first projection matrix is based on the horizontal dimension of the graphics display and the shearing effect of second projection matrix is based on the vertical dimension of the graphics display.

In another embodiment of the computer implemented method the offset distance D is based on a fraction of the viewing distance. The offset distance may be set larger when the display resolution is higher. Also, the offset distance D and the shearing effects of the first and second projection matrices may be determined dependently of each other so that total shearing effect is based on the sum of the effect of the offset distance D and the shearing effect of the first and second projection matrices. The offset distance D may also be adjusted based on the resolution of the graphics display. When the structure of the geometry of the 3D construction site model is very fine, the triangles of the 3D construction site model are smaller, and the shearing of the small triangles generates narrower projections. The projection can be made wider by increasing the offset distance D.

According to an embodiment of the invention, there is an graphics rendering system 80 for generating a real-time two-dimensional cross-section view of a construction site comprising at least one processor 81, a graphics display 86, and at least one memory 82 including computer program code; the at least one memory and the computer program code configured to, with the at least one processor 81, cause the graphics rendering system 80 at least to perform a graphics pipe-line comprising at least a vertex shader and fragment shader, wherein the graphics rendering system 80 is configured to:
- define 101 a cross-section plane of a three-dimensional model of the construction site;
- determine 102 an orthogonal view frustum 25 aligned with the cross-section plane;
- determine 103 an offset plane 31 parallel to the cross-section plane 30 at an offset distance from the cross-section plane 30;
- determine 104 a first orthogonal projection matrix, wherein the first orthogonal projection matrix is sheared in a first direction;
- determine 105 a first orthogonal projection using the first orthogonal projection matrix;
- generate 106 a rasterized image of the orthogonal view frustum 25 with the fragment shader on the cross-section plane 30 based on a resolution of a graphics display;
- test 107 depth of each fragment if each pixel of the fragment with respect to the cross-section plane 30 and the offset plane 31;
- in response to a pixel of a fragment is positioned between the cross-section plane 30 and the offset plane 31, include 108 the pixel of the fragment;
- in response to a pixel of a fragment is not positioned between the cross-section plane 30 and the offset plane 31, discard 109 the pixel of the fragment;
- display 110 the rasterized image from the cross-section plane 30 on the graphics display.

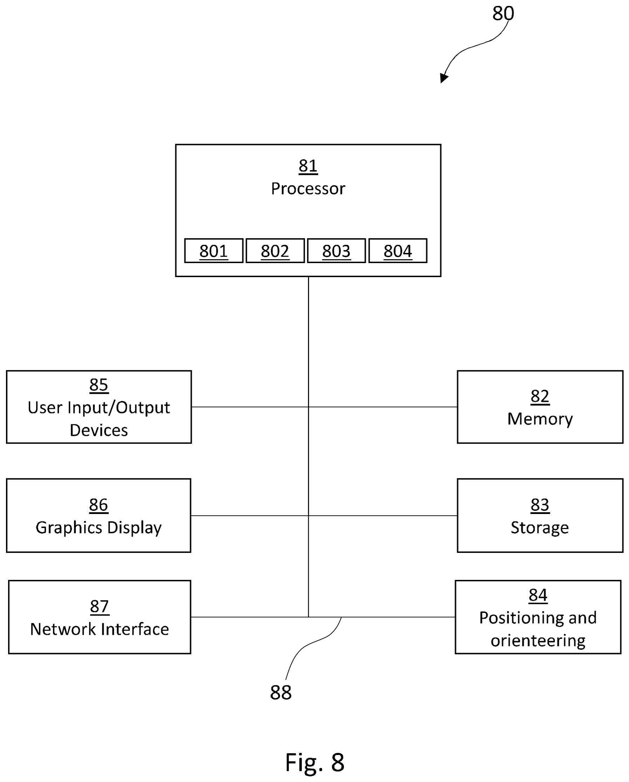

Figure 8 illustrates a graphics rendering system 80 comprising at least one processor 81, a storage 83 hosting the 3D construction site model, at least one memory 82 including computer program code comprising instructions stored thereon to execute the computer implemented method 100 to be loaded from the storage 83 to the memory 82, a graphics display 86 configured to render data from the 3D construction site model among other visual content to a display. The processor may comprise a plurality 801-804 of processors or accelerators. In an aspect, the rendering apparatus 80 may also include a network interface unit 87 configured to connect the graphics rendering system 80 to other computers. A graphics rendering system 80 may receive the 3D construction site data via a computer network from a network. The graphics rendering system may comprise means for positioning and orienteering 84, for example a positioning subsystem, that is configured to identify the coordinates e.g., in GPS coordinates, of the user device and the direction that the user device is pointed towards. Such means for positioning and orienteering are well known in the art. The graphics rendering system 80 retrieves data from based on the computer program code. The graphics rendering system 80 may be connected to the server apparatus via a computer network, where in the computer network may be e.g., a local area network or a wide area network. The achieved frame rate of the graphics rendering system 80 may depend on the type of network connectivity and may thus impact on the performance of the rendering in an interactive 3D construction site visualisation application. In an interactive 3D construction site visualisation application, the speed of data transfer from an external server is essential to achieve a desired frame rate.

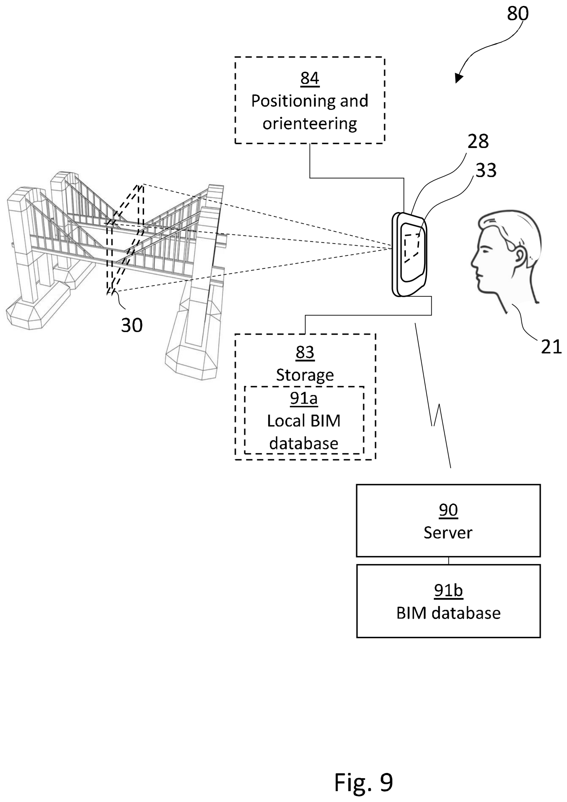

Figure 9 is illustrating the graphics rendering system 80 where the user device 28 is portable device comprising means for positioning 84. The user device 28 may be configured to retrieve the BIM data from a local BIM database 91a of the storage 83 of the user device 28 or via a wireless network from BIM database 91b of a server 90. With the position and orientation information, the user device 28 can render a real-time cross-section view 33 of the construction site, here the bridge, on the display of the user-device 28. It should be noted that the accuracy of the positioning and orienteering depend on the accuracy of the position and orientation information. However, even with limited accuracy of the position and orientation information the real-time cross-section view of the construction site is useful for practical purposes at the construction site. Also, it should be noted that user device may be of different form factor, not only portal. The positioning and orienteering information may be provided also via a user interface of the user device 28 to select a desired viewing point and a cross-section. For obvious reasons, the user may desire to have a real-time cross-section view for any part of the construction site, even the ones the user is not directly facing. The user device 28 may be located at the construction site or at a distance from the construction site. Providing positioning and orienteering information via a user interface is well known in the art.

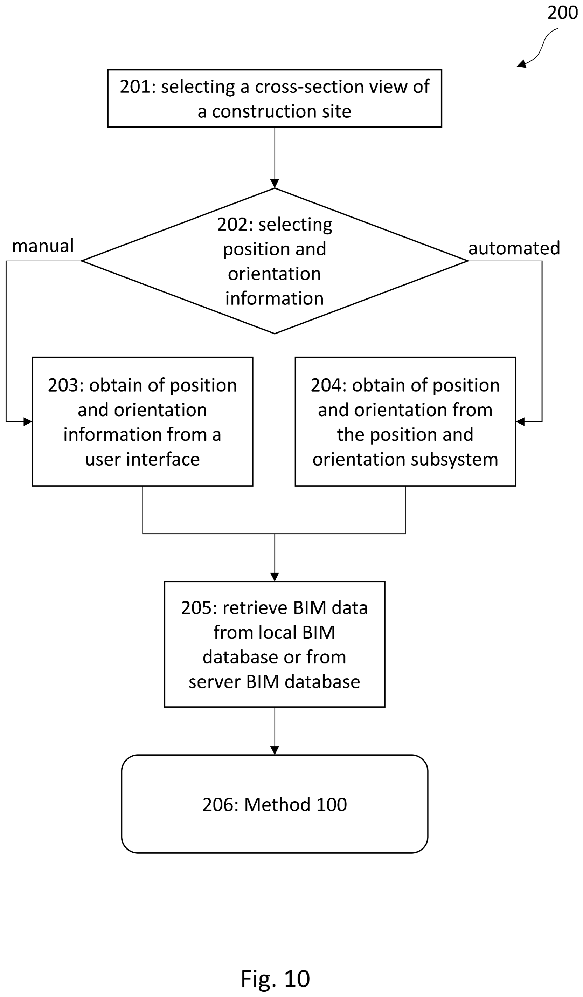

Figure 10 is illustrating schematically the operation of method 200 executed on the graphics rendering system 80 for a real-time cross-section view of a construction site, wherein the graphics rendering system 80 is operated in the user device 28. At 201, a selection of a cross-section view to be viewed is obtained from the user device 28. At 202, a user selection on what type of position and orientation information will be used is obtained. In response to a selection of manual information, the user device 28 obtains 203 the position and orientation information from a user interface of the user device 28. The user device may also obtain the position and orientation information from another software via an application programming interface (API). In response to a selection of automated information, the user device 28 obtains 204 the position and orientation information from the means for positioning and orienteering 84 of the user device. At 205, the user device retrieves the 3D model or the BIM model of the construction site from a local BIM database 91a of the storage 83 of the user device or from BIM database 91b of the server 90, wherein the server is remotely connected to the user device 28, either wirelessly or via a wired connection. At 206, the user device is performing the method 100.

According to an embodiment of the invention, there is a non-transitory, computer-readable medium storing instructions that, when executed by at least one processor 81 of a rendering graphics system 80, perform a method generating a real-time two-dimensional cross-section view of a construction site, comprising at least the following:
- defining 101 a cross-section plane 30 of a three-dimensional model of the construction site;
- determining 102 an orthogonal view frustum 25 aligned with the cross-section plane 30;
- determining 103 an offset plane 31 parallel to the cross-section plane 30 at an offset distance from the cross-section plane 30;
- determining 104 a first orthogonal projection matrix, wherein the first orthogonal projection matrix is sheared in a first direction;
- determining 105 a first orthogonal projection using the first orthogonal projection matrix;
- generating 106 a rasterized image of the orthogonal view frustum 25 with the fragment shader on the cross-section plane 30 based on a resolution of a graphics display;
- testing 107 depth of each fragment if each pixel of the fragment with respect to the cross-section plane 30 and the offset plane 31;
- in response to a pixel of a fragment is positioned between the cross-section plane 30 and the offset plane 31, including 108 the pixel of the fragment;
- in response to a pixel of a fragment is not positioned between the cross-section plane 30 and the offset plane 31, discarding 109 the pixel of the fragment;
- outputting 110 the rasterized image 32 from the cross-section plane 30 to be displayed on the graphics display.

The disclosed method and system reach an efficient rendering of cross-section view of a construction site. The efficiency is achieved well in the case, where the object, e.g., a construction site is fixed and stable in the sense that there are no moving parts. Secondly, there is a 3D model or a BIM data available that can be preloaded to the user device 28, or it can be obtained from the remote server 90. Even if the remote server 90 is used for obtaining the 3D model or the BIM data of the construction site, the speed of the remote connection may not limit the real-time view cross-section view of the construction site, if the user device is configured to sufficiently buffer the 3D model or BIM data of the construction site. Such buffering schemes are commonly known in the art.

It will be obvious to a person skilled in the art that, as the technology advances, the inventive concept can be implemented in various ways. The invention and its embodiments are not limited to the examples described above but may vary within the scope of the claims.

## Claims

1. A computer implemented method (100) for generating a real-time two-dimensional cross-section view of a construction site with a graphics pipeline comprising at least a vertex shader and fragment shader, the method comprising:
defining (101) a cross-section plane (30) of a three-dimensional model of the construction site;
determining (102) an orthogonal view frustum (25) aligned with the cross-section plane (30);
determining (103) an offset plane (31) parallel to the cross-section plane (30) at an offset distance (D) from the cross-section plane (30);
determining (104) a first orthogonal projection matrix, wherein the first orthogonal projection matrix is sheared in a first direction;
determining (105) a first orthogonal projection of polygons using the first orthogonal projection matrix;
generating (106) a rasterized image of the polygons of the orthogonal view frustum (25) with the fragment shader on the cross-section plane (30) based on a resolution of a graphics display;
testing (107) depth of each fragment if each pixel of the fragment with respect to the cross-section plane (30) and the offset plane (31);
in response to a pixel of a fragment is positioned between the cross-section plane (30) and the offset plane (31), including (108) the pixel of the fragment;
in response to a pixel of a fragment is not positioned between the cross-section plane (30) and the offset plane (31), discarding (109) the pixel of the fragment; and
displaying (110) the rasterized image from the cross-section plane (30) on the graphics display.

2. A computer implemented method according to claim 1, wherein a second orthogonal projection matrix is determined, wherein the second orthogonal projection matrix is sheared in a different direction than the first orthogonal projection matrix, and second pass of the fragment shader is performed with the second orthogonal shader.

3. A computer implemented method according to claim 2, wherein the second orthogonal projection matrix is sheared in a direction approximately 90 degrees with respect to the than the first orthogonal projection matrix.

4. A computer implemented method according to any preceding claim 1-3, wherein at least one of the first and the second orthogonal projection matrices are determined also based on the resolution of the display.

5. A computer implemented method according to any preceding claim, wherein at least one of the first and the second orthogonal projection matrices are determined also based on the aspect ratio of the display.

6. A computer implemented method according to any preceding claim, wherein the offset distance is based on a fraction of the viewing distance.

7. A graphics rendering system (80) for generating a real-time two-dimensional cross-section view of a construction site comprising at least one processor (81), a graphics display (86), and at least one memory (82) including computer program code; the at least one memory and the computer program code configured to, with the at least one processor (81), cause the graphics rendering system (80) at least to perform a graphics pipeline comprising at least a vertex shader and fragment shader, wherein the graphics rendering system (200) is configured to:
define (201) a cross-section plane (30) of a three-dimensional model of the construction site;
determine (202) an orthogonal view frustum (25) aligned with the cross-section plane (30);
determine (203) an offset plane (31) parallel to the cross-section plane (30) at an offset distance from the cross-section plane (30);
determine (204) a first orthogonal projection matrix, wherein the first orthogonal projection matrix is sheared in a first direction;
determine (205) a first orthogonal projection of polygons using the first orthogonal projection matrix;
generate (206) a rasterized image of the polygons of the orthogonal view frustum (25) with the fragment shader on the cross-section plane (30) based on a resolution of a graphics display;
test (207) depth of each fragment if each pixel of the fragment with respect to the cross-section plane (30) and the offset plane (31);
in response to a pixel of a fragment is positioned between the cross-section plane (30) and the offset plane (31), include (208) the pixel of the fragment;
in response to a pixel of a fragment is not positioned between the cross-section plane (30) and the offset plane (31), discard (209) the pixel of the fragment; and
display (210) the rasterized image from the cross-section plane (30) on the graphics display.

8. A graphics rendering system (80) according to claim 7, comprising instructions to execute any of the methods of claims 2-6.

9. A non-transitory, computer-readable medium storing instructions that, when executed by at least one processor of a rendering graphics system, perform a method generating a real-time two-dimensional cross-section view of a construction site, comprising at least the following:
defining (101) a cross-section plane (30) of a three-dimensional model of the construction site;
determining (102) an orthogonal view frustum (25) aligned with the cross-section plane (30);
determining (103) an offset plane (31) parallel to the cross-section plane (30) at an offset distance from the cross-section plane (30);
determining (104) a first orthogonal projection matrix, wherein the first orthogonal projection matrix is sheared in a first direction;
determining (105) a first orthogonal projection of polygons using the first orthogonal projection matrix;
generating (106) a rasterized image of the polygons of the orthogonal view frustum (25) with the fragment shader on the cross-section plane (30) based on a resolution of a graphics display;
testing (107) depth of each fragment if each pixel of the fragment with respect to the cross-section plane (30) and the offset plane (31);
in response to a pixel of a fragment is positioned between the cross-section plane (30) and the offset plane (31), including (108) the pixel of the fragment;
in response to a pixel of a fragment is not positioned between the cross-section plane (30) and the offset plane (31), discarding (109) the pixel of the fragment; and
displaying (110) the rasterized image from the cross-section plane (30) on the graphics display.

10. A non-transitory, computer-readable medium storing instructions according to claim 9, comprising instructions to execute any of the methods of claims 2-6.
